(19) Europäisches Patentamt
European Patent Office
Office européen des brevets

(11) Publication number: 0 318 324 A2

# (12) EUROPEAN PATENT APPLICATION

(21) Application number: 88311221.1

(22) Date of filing: 25.11.88

(51) Int. Cl.[4]: G 03 F 7/10

(30) Priority: 27.11.87 JP 299315/87
27.11.87 JP 299316/87
27.11.87 JP 299317/87
25.11.88 JP 295969/88

(43) Date of publication of application:
31.05.89 Bulletin 89/22

(84) Designated Contracting States: BE DE FR GB NL

(71) Applicant: TOSOH CORPORATION
4560, Oaza-Tonda Shinnanyo-shi
Yamaguchi 746 (JP)

Matsushita Electric Industrial Co., Ltd.
1006 Oaza Kadoma
Kadoma-shi Osaka (JP)

(72) Inventor: Endo, Masayuki
782, Kurodori-cho
Izumi-shi Osaka (JP)

Sasago, Masaru
1-1-3-14, Kohoku
Hirakata-shi Osaka (JP)

Kazufumi, Ogawa
30-5, Higashinakaburi 1-chome
Hirakata-shi Osaka (JP)

Hasegawa, Masazumi
10-3-118, Madokoro 4-chome
Shinnanyo-shi Yamaguchi (JP)

Sakurai, Ikuo
3056-1, Tonda
Shinnanyo-shi Yamaguchi (JP)

(74) Representative: Beresford, Keith Denis Lewis et al
BERESFORD & Co. 2-5 Warwick Court High Holborn
London WC1R 5DJ (GB)

## (54) Photosensitive resin composition and method for forming patterns using the same.

(57) A photosensitive resin composition comprising a diazonium salt as a photobleachable agent, a polymer, and water and/or an organic solvent is disclosed, wherein said diazonium salt has a counter anion containing a sulfo group or said polymer contains a sulfo group or a salt thereof. Since the diazonium salt sensitive to i-line can be dissolved in a large quantity in a photosensitive resin composition while exhibiting improved stability, fine patterns of about 0.5 μm can be formed stably with satisfactory resolution.

EP 0 318 324 A2

**Description**

**PHOTOSENSITIVE RESIN COMPOSITION AND METHOD FOR FORMING FINE PATTERNS USING THE SAME**

## FIELD OF THE INVENTION

This invention relates to a photosensitive resin composition for forming fine patterns in the field of semiconductor and a method for producing fine patterns using the same. More particularly, it relates to a photosensitive resin composition which is applied to a resist and exposed to light to form a fine pattern having improved dimensional precision and improved resolution.

## BACKGROUND OF THE INVENTION

With the increase of integration scale of semiconductors, there is an increasing tendency to reduction of patterns in size. In recent years, it has been demanded to produce a high-precise pattern profile of 1 μm or less in line width, and various methods have been proposed to meet this demand.

For example, from the aspect of apparatus, use of a light source of shorter wavelengths and use of a lens having a large numerical aperture have been proposed as promising to increase the resolution based on optical theory, and pilot machines are on the market. It has been pointed out, however, that use of a light source having shorter wavelengths results in reduction of the transmittance of a lens, failing to obtain a sufficient quantity of light. On the other hand, use of a lens having a large numerical aperture gives rise to a problem that such a lens can hardly cope with unevenness of the coated resist surface due to its shallower focal depth.

From the aspect of a resist, development of a resist having high contrast (hereinafter referred to as "high-gamma resist") has been attempted. A high-gamma resist surely improves the resolution to some extent. Although the high-gamma resist can be produced through control of molecular weight and degree of dispersion of a polymer in the resist, there is a restriction on the material to be used, and a great improvement on resolution has not yet been reached.

From the aspect of lithography, there have been proposed a method of using a multi-layer resist and a method of coating a photosensitive resin on a resist film.

The method of using a multi-layer resist provides patterns having a high resolution of 1 μm or less, but is still unsatisfactory as industrial technique because the process involved is complicated and time-consuming for the production of semiconductor devices and also the productivity is low.

The aim of the method of coating a photosensitive resin on a resist film lies in improvement of resolution through the following mechanism. A light immediately after passing through a mask has high contrast, but the contrast is reduced after the light passes through a space and a lens. The thus reduced contrast of the light can be again enhanced on passage through the photosensitive resin layer to thereby improve the resolution.

The photosensitive resin contains a photobleachable material. The photobleachable material so far proposed includes nitron compounds as disclosed in JP-A-59-104642 (the term "JP-A" as used herein means an "unexamined published Japanese patent application") and diazonium salts as disclosed in JP-A-60-238829.

According to the method of using the nitron compound, improvement on resolution may certainly result. This method, however, requires formation of an interlayer between a resist as a lower layer and a photosensitive resin layer as an upper layer. The process is thus complicated, and the productivity cannot be so increased as expected.

The method of using the diazonium salt is still unsatisfactory in terms of improvement on resolution in using i-line (365 nm) for exposure. In addition, the diazonium salt to be used leaves room for improvement on preservation stability. Namely, neither resolution of 0.5 μm nor long-term preservability of the material used has been achieved.

The inventors have conducted studies on the above-described technique using a resist having provided thereon a photosensitive resin layer which is bleached by light. A particular aim was taken at the use of a diazonium salt as a photobleachable reagent in a method in which the photosensitive layer (upper layer) and the resist (lower layer) can be developed simultaneously, expecting that the process would be simplified and also resolution would be greatly improved.

In studying, evaluations were made by means of a method for evaluating the mechanism of positive photoresists as reported in F.H. Drill et al., Characterization of Positive Photoresist, IEEE Transactions on Electron Devices, Vol. ED-22, No. 7, IBM Corp., U.S.A. (July, 1975). As a result, the inventors have found that resolution can be greatly improved by increasing an A value as defined below.

The A value is generally represented by equation.

$$A = \frac{1}{d} ln \frac{T(\infty)}{T(0)}$$

where T(0) represents an initial transmittance; T(∞) represents a final transmittance; and d represents a film thickness.

The A value can be increased by reducing the film thickness (d), giving a high transmittance to the photosensitive layer (upper layer) after bleaching (i.e., getting the value of T(∞) closer to 100% as possible), and reducing the initial transmittance T(0) as low as possible. Reduction of T(0) can be achieved by increasing the concentration of a diazonium salt as a photobleachable reagent in the photosensitive layer. It should be noted, however, that the increase of the diazonium salt concentration is accompanied by precipitation of crystals of the photobleachable agent after coating, which rather results in reduction of the resolution.

In an attempt to increase solubility of a diazonium salt, it has been suggested to add an additive, such as sulfonic acid derivatives or salts thereof as disclosed in JP-A-60-238829. This method proved ineffective because of limitation to amount of the additive which can be added without impairing coating properties.

In addition to the problem stated above, the diazonium salt of interest has poor heat stability.

The inventors have hence investigated possibility of improving stability of a diazonium salt by addition of a stabilizer commonly known for diazonium salts, e.g., phosphoric acid, organic phosphoric acids, citric acid, tartaric acid, etc. Since some improving effects were confirmed, addition of a large quantity of such an additive was tried to see if further improvement could be obtained. As a result, the coating properties were deteriorated, and the resolution was reduced.

## SUMMARY OF THE INVENTION

One object of this invention is to provide a photosensitive resin composition which is applicable to production of fine patterns by exposure to i-line with high precision through a simple process.

Another object of this invention is to provide a method for forming fine patterns using the above-described photosensitive resin composition.

In order to overcome the various problems stated above, the inventors have continued further investigations on the technique which comprises coating a resist on a substrate to form a lower layer, further coating thereon a photosensitive resin containing a diazonium salt as a photobleachable agent to form an upper layer, and simultaneously exposing both the upper and lower layers to light. It has now been found, as a result, that fine patterns can be obtained by using a photosensitive resin composition containing a diazonium salt whose counter anion is a compound containing a sulfonic acid group or a photosensitive resin composition containing a polymer having a sulfo group or a salt thereof. The present invention has been completed based on these findings.

## BRIEF DESCRIPTION OF THE ACCOMPANYING DRAWINGS

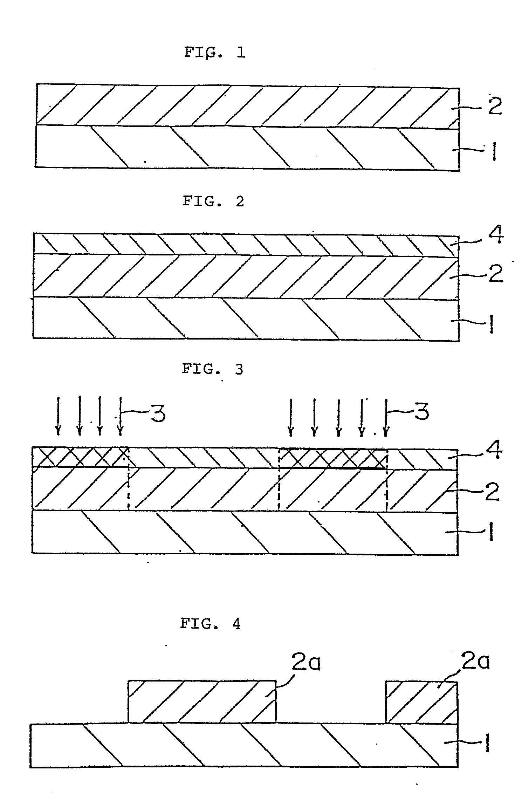

Figures 1 to 4 each illustrates the process for pattern formation according to the present invention.

## DETAILED DESCRIPTION OF THE INVENTION

The counter anion which can be used in the present invention is not particularly limited and includes, for example, $^{\ominus}HSO_4$ and organic carboxylic acids. Any of compounds containing an organic acid group or a sulfo group having a low pKa can be used. Preferred of them are compounds represented by formula (I):

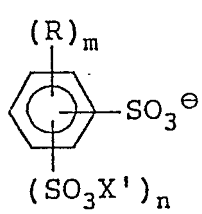

(I)

wherein R represents a hydrogen atom, an alkyl group, an aryl group, an aralkyl group, an alkoxy group, a phenyl group, a halogen atom, a hydroxyl group or a carboxyl group; X′ represents a hydrogen atom, a lithium

atom, a sodium atom, a potassium atom or an ammonium group; and m and n each represents 0 or an integer of from 1 to 5, provided that the sum of them is not more than 5, and/or those represented by formula (II):

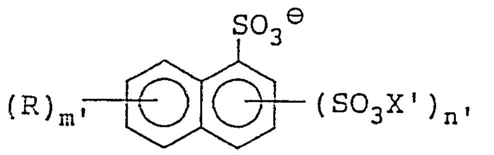

(II)

wherein R and X′ are as defined above; and m′ and n′ each represents 0 or an integer of from 1 to 7, provided that the sum of them is not more than 7.

There is no particular limitation to the molar ratio of the diazo group in the diazonium salt to the sulfo group in these compounds, but the sulfo group to diazo group molar ratio is preferably 1.1/1 or more.

The polymer which can be used in the photosensitive resin composition of the present invention includes any polymers which are, when dissolved in water, dissociated into ions to have a pKa of 2 or less. Preferred of them are those having a sulfo group, such as polyvinylsulfonic acid, chondroitin sulfuric acid, and salts of these acids. Particularly preferred are those having a benzenesulfonic acid group-containing structural unit as represented by formula (III):

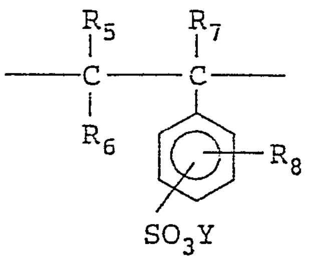

(III)

wherein $R_5$, $R_6$, and $R_7$ each represents a hydrogen atom, an alkyl group having from 1 to 4 carbon atoms, a halogen atom or a nitrile group; $R_8$ represents a hydrogen atom, an alkyl group having from 1 to 4 carbon atoms, a halogen atom, a hydroxyl group or a carboxyl group; and Y represents a hydrogen atom, an alkali metal atom, an alkaline earth metal atom or an ammonium group.

It has been confirmed that use of the polymer having a benzenesulfonic acid group in the photosensitive resin composition enhances not only solubility of a diazonium salt in a solvent, inhibiting precipitation of the diazonium salt crystals, but also stability of the diazonium salt.

The polymer having the unit of formula (III) may be a copolymer of comonomers selected from among compounds providing the unit of formula (III) or a copolymer of a compound providing the unit of formula (III) and other generally known copolymerizable compounds.

Examples of the compounds copolymerizable with the compound providing the unit of formula (III) are styrene, α-methylstyrene, vinylpyridine, acenaphthylene, vinylaniline, vinylnaphthalene, vinylacetophenone, acrylic acid or derivatives thereof, methacrylic acid or esters thereof, acrylonitrile, maleic anhydride, maleimide or derivatives thereof, allyl esters, vinyl esters, acrolein, acrylamide or modified products thereof, propenylanisole, vinyl ethers, indene, isoprene, and so on.

The copolymerization ratio of the benzenesulfonic acid group-containing structural unit to other copolymerizable compound, such as those enumerated above, is not particularly restricted, but it is preferred that the polymer contains at least 50 mol% of the benzenesulfonic acid group-containing unit.

The solvent in the photosensitive resin composition may be any of known compounds as long as it does not dissolve the lower resist layer, with water being preferred.

If desired, the photosensitive resin composition of the invention may further contain additives, such as phosphoric acid, benzenesulfonic acid or salts thereof, sulfosalicylic acid or salts thereof, nicotinic acid, caffeine, etc.

The inventors conducted further extensive investigations on polymers in the photosensitive layer. As a result, it has also been found that a functional group in the polymer of the photosensitive layer can be made use of as a counter anion of a diazonium ion, thereby making it possible to dissolve a large quantity of the diazonium salt in a solvent without impairing coating properties and, at the same time, improving stability of the diazonium slat. That is, this pattern formation technique is characterized in that the counter anion of the diazonium ion is a functional group of the polymer present in the photosensitive layer.

The polymer which can be used in the photosensitive resin composition of the present invention includes

any polymers which are, when dissolved in water, dissociated into ions to have a low pKa. Preferred of them are those having a sulfo group, such as polyvinylsulfonic acid, chondroitin sulfuric acid, and salts of these acids. Particularly preferred are those having a structural unit represented by formula (IV):

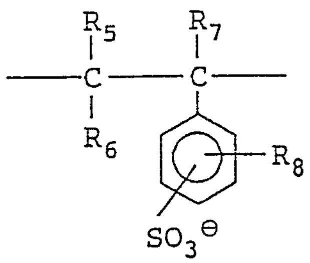

(IV)

wherein $R_5$, $R_6$, $R_7$, and $R_8$ are as defined above.

The counter cation of these polymers includes the counter cation such as the diazonium ion in the photosensitive resin composition as well as a hydrogen ion, an alkali metal ion, an alkaline earth metal ion, an ammonium ion, etc.

The polymer for this use may be a copolymer of comonomers selected from among compounds providing the structural unit of formula (IV) or a copolymer of the compound providing the structural unit of formula (IV) and other generally known copolymerizable compounds.

Examples of the compounds copolymerizable with the compound providing the unit of formula (III) are styrene, α-methylstyrene, vinylpyridine, acenaphthylene, vinylaniline, vinylnaphthalene, vinylacetophenone, acrylic acid or derivatives thereof, methacrylic acid or esters thereof, acrylonitrile, maleic anhydride, maleimide or derivatives thereof, allyl esters, vinyl esters, acrolein, acrylamide or modified products thereof, propenylanisole, vinyl ethers, indene, isoprene, and so on.

The copolymerization ratio of the benzenesulfonic acid group-containing structural unit to other copolymerizable compound, such as those enumerated above, is not particularly restricted, but it is preferred that the polymer contains at least 50 mol% of the benzenesulfonic acid group-containing unit.

In these polymers, the molar ratio of the functional group serving as a counter anion of the diazonium salt to free functional groups is not particularly limited, but the proportion of free functional groups is preferably at least 30% based on the total functional groups.

If desired, the photosensitive resin composition of the invention may further contain additives known as stabilizer for diazonium salts, such as phosphoric acid, organic acids, citric acid, tartaric acid, etc.

The photosensitive resin composition containing a diazonium salt and a polymer in which the counter anion of the diazonium salt is a functional group of the polymer can be prepared, for example, by mixing an aqueous solution of a diazonium salt with a stoichiometrical excess of the above-described polymer and then removing low-molecular weight salts by dialysis or the like technique.

With respect to diazonium salts, it has been proved that a diazonium salt whose counter cation is represented by formulae (V) and/or (VI):

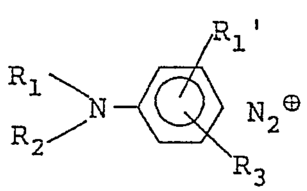

(V)

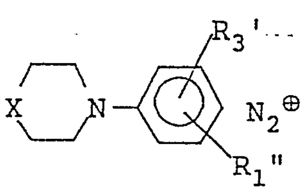

(VI)

wherein $R_1$, $R_1'$, $R_1''$, and $R_2$ each represents a hydrogen atom, an alkyl group or an acetyl group; $R_3$ and $R_3'$

each represents a hydrogen atom, an alkyl group, an acetyl group, a hydroxyl group, an alkoxy group, a halogen atom or a nitrile group; and X represents an oxygen atom, a sulfur atom or $NR_4$, wherein $R_4$ represents a hydrogen atom, an alkyl group or an acetyl group,
has an absorption maximum near to the wavelength of i-line (ca. 365 nm) and shows a higher solubility to the above-described counter anion as compared with other diazonium salts by 30 to 40%.

Use of such a diazonium salt provides a photosensitive layer having its A value increased to 10 or greater, which is suitable for resolution of patterns of, for example, 0.5 μm, the minimum module of 16 MB DRAM in the processing.

The method for forming fine patterns according to the present invention is described below in detail.

A commonly employed resist, preferably a positive photoresist, is spin-coated on a wafer. Any positive photoresist can be used here as long as a developing solution therefor is capable of simultaneously removing the photosensitive resin off the wafer by dissolving. The resist thus coated is subjected to prebaking. Thereafter, a photosensitive resin composition comprising the diazonium salt and polymer according to the present invention, and water and/or an organic solvent is spin-coated on the resist layer.

The resulting coated material is exposed to light rays to which both the upper and lower layers are sensitive and then treated with a developing solution for the resist, thereby developing the resist and, at the same time, removing the photosensitive resin layer off the wafer to form a fine pattern of the resist on the wafer.

According to the present invention, a large quantity of a diazonium salt sensitive to i-line can be dissolved in a photosensitive resin composition to thereby increase the A value, indicative of improvement of resolution. The present invention also achieves improvement on stability of diazonium salts. The present invention hence makes it possible to form a resist pattern of about 0.5 μm in line width with satisfactory stability and resolution.

The present invention is now illustrated in greater detail by way of the following examples, but it should be understood that the present invention is not deemed to be limited thereto.

## PREPARATION EXAMPLE 1

To an aqueous solution of 4-morpholinobenzenediazonium chloride synthesized in a conventional manner was added 2 equivalents of 1,5-naphthalenedisulfonic acid. A diazonium salt was allowed to precipitate through salting out. The precipitate collected was dried in vacuo to give a powdery diazonium salt.

## EXAMPLE 1

To 7.2 g of the diazonium salt obtained in Preparation Example 1 were added 10 g of sodium polystyrenesulfonate ("PS-5", produced by Tosoh Corporation; molecular weight: 50,000) and 90 g of water to prepare a photosensitive resin aqueous solution.

The photosensitive resin aqueous solution was spin-coated on a quartz substrate to form a uniform thin film having a thickness of 0.25 μm. The A value of the film at 365 nm was calculated from the transmittances before and after exposure and was found to be 11.5.

The photosensitive resin aqueous solution was then allowed to stand in a thermostat set at 35° C for 25 days. The A value after the standing was found to be 11.5. The coating film of the solution after the standing showed no change of film thickness. Preservation stability of the photosensitive resin solution was thus proved satisfactory.

## COMPARATIVE EXAMPLE 1

An aqueous photosensitive resin solution was prepared by mixing 3 g of a 4-morpholinobenzenediazonium 1/2·$ZnCl_2$ salt as a diazonium salt, 10 g of polyvinylpyrrolidone (produced by Nakarai Kagaku Yakuhin Co., Ltd.; molecular weight: 24,500), and 90 g of water. The A value as determined in the same manner as in Example 1 was 4.6.

When the diazonium salt was dissolved in a concentration higher than the above, the resulting solution underwent precipitation of crystals upon coating, failing to form a uniform film.

The A value as determined after preservation at 35° C for 20 days in the same manner as in Example 1 was found to be 1.6, that was too low for application to practical use.

## EXAMPLE 2

The pattern formation according to the present invention is illustrated by referring to Figs. 1 to 4.

A positive photoresist 2 ("OFPR-800" produced by Tokyo Ohka Kogyo Co., Ltd.) was coated on a silicon wafer 1 to a thickness of 0.9 μm and prebaked at 80° C for 10 minutes (Fig. 1). The photosensitive resin solution 4 as prepared in Example 1 was then coated thereon to a thickness of 0.25 μm (Fig. 2).

The coated material was exposed to an i-line light 3 (at 365 nm) by means of an i-line 10/1-reduction

projection exposure apparatus (stepper) equipped with a lens having a numerical aperture of 0.42 (Fig. 3), and then developed with a developer ("NMD-3" produced by Tokyo Ohka Kogyo Co., Ltd.) (Fig. 4). A close observation of the cross section of the resist pattern under the electron microscope revealed that there was formed a 0.50 µm line/space pattern 2a having rectangular steep edges.

## COMPARATIVE EXAMPLE 2

A resist pattern was produced in the same manner as in Example 2, except for omitting the coating of the photosensitive resin solution. In this case, the exposure required for pattern transfer was about 1/2 of that in Example 1. An electron microscopic observation revealed that a 0.6 µm pattern could not be resolved.

## COMPARATIVE EXAMPLE 3

Pattern transfer was carried out in the same manner as in Example 2, except for replacing the photosensitive resin solution as used in Example 2 with that prepared in Comparative Example 1. As a result, the resist could not resolve a 0.5 µm pattern and, besides, the resulting resist pattern had a poor shape and a low contrast of 65°, which showed unsuitability for practical use.

## PREPARATION EXAMPLE 2

A diazonium compound of formula shown below was synthesized in a known manner:

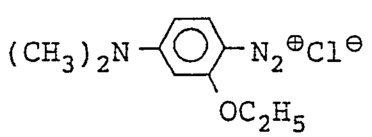

Two equivalents of 1,5-naphthalenedisulfonic acid was added to the compound to precipitate a diazonium salt through salting out. The precipitate collected was dried in vacuo to obtain a powder.

To 9.5 g of the powder were added 10 g of ammonium polystyrenesulfonate (obtainable by replacing sodium in PS-5 by ammonium by using an ion-exchange resin followed by dehydration to dryness) and 90 g of water to prepare a photosensitive resin solution.

## EXAMPLE 3

The photosensitive resin solution of Preparation Example 2 was spin-coated on a quartz substrate to form a uniform thin film having a thickness of 0.29 µm. The A value of the film at 365 nm was found to be 12.2. When the photosensitive resin solution was left to stand in a thermostat set at 35° C for 20 days, the film formed in the same manner as described above had an A value of 12.2 and showed no deterioration of coating properties, indicating satisfactory preservability of the photosensitive resin solution.

## COMPARATIVE EXAMPLE 4

A photosensitive resin solution was prepared by mixing 1.8 g of a diazonium salt of formula:

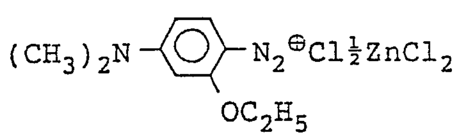

10 g of polyvinylpyrrolidone as used in Comparative Example 1, and 90 g of water. The A value was found to be 4.8.

When the above diazonium salt was further dissolved in the photosensitive resin solution, crystals of the

diazonium salt were precipitated on coating, failing to form a uniform film.

After the photosensitive resin solution was allowed to stand in a thermostat set at 35° C for 20 days, the A value was found to be 1.2, which was too low to be used for practical use.

## EXAMPLE 4

A positive photoresist "OFPR-800" was spin-coated on a silicon wafer to a thickness of 0.9 µm and prebaked at 80° C for 10 minutes. The photosensitive resin solution prepared in Preparation Example 2 was then coated thereon to a film thickness of 0.22 µm. The coated material was exposed to light by means of an i-line 10/1 stepper equipped with a lens having a numerical aperture of 0.42 and then developed with a developer "NMD-3". An electron microscopic observation of the cross section of the resist pattern revealed that there was formed a rectangular and sharp 0.5 µm line/space pattern.

## COMPARATIVE EXAMPLE 5

The procedure of Example 4 was repeated, except for using the photosensitive resin solution prepared in Comparative Example 4 in place of the photosensitive resin solution prepared in Preparation Example 2. In this case, the exposure required was less than that of Example 4 by 30%. A close observation under the electron microscope revealed that the resolution was 0.8 µm.

## PREPARATION EXAMPLE 3

In order to evaluate stability of a diazonium salt, 100 ml of a photosensitive resin solution was prepared by mixing 10 g of sodium polystyrenesulfonate "PS-5", 4.8 g of a 4-morpholinobenzenediazonium chloride 1/2·zinc chloride complex salt, and 90 g of water.

## EXAMPLE 5

The photosensitive resin aqueous solution prepared in Preparation Example 3 was spin-coated on a quartz substrate to form a uniform thin film having a thickness of 0.35 µm. The A value of the film at 365 nm was found to be 12.0. When the same photosensitive resin aqueous solution was allowed to stand in a thermostat set at 35° C for 20 days in a dark place, the A value was 11.9, indicating satisfactory preservability of the photosensitive resin solution.

## COMPARATIVE EXAMPLE 6

A photosensitive resin aqueous solution was prepared by mixing 3 g of a 4-morpholinobenzenediazonium chloride 1/2·zinc chloride complex salt, 10 g of polyvinylpyrrolidone as used in Comparative Example 1, and 90 g of water. The A value at 365 nm was 4.6.

When an additional amount of the diazonium salt was further dissolved in the solution, crystals of the diazonium salt precipitated on coating, failing to form a uniform film. When the photosensitive resin solution was allowed to stand at 35° C for 20 days in a dark place, the A value was found to be 1.6, showing unsuitability for practical use.

## EXAMPLE 6

A positive photoresist "OFPR-800" was spin-coated on a silicon wafer to a thickness of 0.9 µm and prebaked at 80° C for 10 minutes. The photosensitive resin solution comprising 4.8 g of a 4-morpholino-2-ethoxybenzenediazonium chloride 1/2·zinc chloride complex salt, 10 g of sodium polystyrenesulfonate, and 90 g of water was then coated thereon to a thickness of 0.35 µm.

The resulting coated material was exposed to light by the use of an i-line 10/1 stepper equipped with a lens having numerical aperture of 0.42 to transfer a mask pattern to the coating and then developed with a developer "NMD-3" for 1 minute. An electron microscopic observation of the cross section of the resist revealed that a rectangular sharp 0.5 µm line/space pattern had been formed.

## COMPARATIVE EXAMPLE 7

The procedure of Example 6 was repeated, except for omitting the coating of the photosensitive resin

solution. In this case, the exposure required for pattern transfer was the half of that in Example 6. As a result of electron microscopic observation, the resolution was found to be 1.2 µm.

EXAMPLE 7

The procedure of Example 6 was repeated, except for replacing the sodium polystyrenesulfonate as used in Example 6 with polystyrenesulfonic acid. As a result, the resolution was 0.5 µm.

COMPARATIVE EXAMPLE 8

A photosensitive resin solution was prepared in the same manner as in Example 6, except for replacing the sodium polystyrenesulfonate with polyvinylpyrrolidone as used in Comparative Example 1. When the photosensitive resin solution was coated on the resist film, crystallization of the diazonium salt was observed. The coated material was processed in the same manner as in Example 6. An electron microscopic observation revealed that no sharp pattern was obtained, and the resolution was unmeasurable.

EXAMPLE 8

The procedure of Example 6 was repeated, except for replacing the diazonium salt as used in Example 6 with a 4-(N,N-dimethylamino)-2-ethoxybenzenediazonium chloride 1/2 zinc chloride complex salt. The resolution was found to be 0.5 µm.

PREPARATION EXAMPLE 4

To an aqueous solution of 4-morpholinobenzenediazonium chloride was added 2 equivalents of sodium polystyrenesulfonate ("PS-5"), and low-molecular weight salts, such as sodium chloride, were removed by the use of a commercially available dialysis membrane made of cellulose ("Spectra/Poac" produced by Spectrum Co., Ltd.) to obtain a 15 wt% photosensitive resin aqueous solution containing a polystyrenesulfonate carrying a sulfo group serving as a counter anion of the diazonium compound and a free sulfo group at a molar ratio of 1:1.

EXAMPLE 9

The photosensitive resin aqueous solution prepared in Preparation Example 4 was spin-coated on a quartz substrate to form a uniform thin film having a thickness of 0.35 µm. The A value of the film at 365 nm was found to be 10.5. After the photosensitive resin aqueous solution was allowed to stand at 35°C for 20 days in a dark place, the A value was found to be 10.5, indicating satisfactory preservability of the photosensitive resin solution.

COMPARATIVE EXAMPLE 9

A photosensitive resin aqueous solution was prepared by mixing 3 g of a 4-morpholinobenzenediazonium chloride 1/2·zinc chloride complex salt, 10 g of polyvinylpyrrolidone as used in Comparative Example 1, and 90 g of water. The A value at 365 nm was 6.5. When an additional amount of the diazonium salt was dissolved in the solution, crystals of the diazonium salt precipitated on coating, failing to form a uniform film. After the photosensitive resin aqueous solution was left to stand at 35°C for 20 days in a dark place, the A value was found to be 1.6, indicating unsuitability for practical use.

EXAMPLE 10

A positive photoresist "OFPR-800" was spin-coated on a silicon wafer to a film thickness of 0.9 µm and prebaked at 80°C for 10 minutes. The photosensitive resin aqueous solution prepared in Preparation Example 4 was coated thereon to a film thickness of 0.35 µm.

The resulting coated material was exposed to light by means of an i-line 10/1 stepper equipped with a lens having a numerical aperture of 0.42 to transfer a mask pattern to the coating and then developed with a developer "NMD-3" for 1 minute. The cross section of the resist pattern was observed under the electron microscope and, as a result, it was revealed that a 0.5 µm line/space pattern having rectangular steep edges was formed.

## COMPARATIVE EXAMPLE 10

A resist pattern was obtained in the same manner as in Example 10, except for omitting the coating of the photosensitive resin solution. In this case, the exposure required was about 1/2 of that in Example 10. Observation under the electron microscope revealed that a pattern of 0.5 μm could not be resolved.

## COMPARATIVE EXAMPLE 11

Pattern transfer was carried out according to a conventional technique. That is, the procedure of Example 10 was repeated, except for replacing the photosensitive resin solution as used in Example 10 with the photosensitive resin solution obtained in Comparative Example 9. An electron microscopic observation reveled that a pattern of 0.5 μm could not be resolved and, besides, the shape of the resist pattern obtained was too poor to be used in practice. Namely, the resulting pattern suffered from reduction, and its contrast was as low as 65°.

## EXAMPLE 11

A 13.5 wt% photosensitive resin aqueous solution was prepared in the same manner as in Preparation Example 4, except for using 4-(N,N-dimethylamino)-2-ethoxybenzenediazonium chloride as a diazonium salt. The A value at 365 nm was found to be 12.0.

A positive photoresist "OFPR-800" was coated on a silicon wafer to a film thickness of 1.0 μm and prebaked at 80°C for 10 minutes. The above prepared photosensitive resin aqueous solution was then coated thereon to a film thickness of 0.30 μm.

The resulting coated material was exposed to light by means of a 10/1 stepper equipped with a lens having a numerical aperture of 0.42 and then developed with a developer "NMD-3" for 1 minute. An electron microscopic observation of the cross section of the resulting resist pattern revealed that there was obtained a 0.5 μm line/space pattern having steep edges.

## COMPARATIVE EXAMPLE 12

A resist pattern was obtained in the same manner as in Example 11, except the photosensitive resin was not coated. In this case, the exposure required was about 2/3 of that in Example 10. As a result of observation under the electron microscope, the resolution was 0.8 μm.

## EXAMPLE 12

A 14 wt% photosensitive resin aqueous solution was prepared in the same manner as in Preparation Example 4, except for using 4-(N,N-dimethylamino)-2-methoxybenzenediazonium chloride as a diazonium salt and polystyrenesulfonic acid as a polymer. When pattern transfer was carried out by using the resulting photosensitive resin aqueous solution in the same manner as in Example 11, a 0.5 μm line/space pattern could be resolved similarly to Example 11.

As described above, the photosensitive resin composition in accordance with the present invention exhibits satisfactory stability and produces remarkable effects to improve contrast. The present invention makes it possible to again increase a reduced contrast of light to a high level without involving complicated processes or using labile materials, to thereby form a fine pattern of about 0.5 μm with good precision.

While the invention has been described in detail and with reference to specific embodiments thereof, it will be apparent to one skilled in the art that various changes and modifications can be made therein without departing from the spirit and scope thereof.

**Claims**

1. A photosensitive resin composition comprising a diazonium salt as a photobleachable reagent, a polymer, and water and/or an organic solvent, wherein said diazonium salt has a counter cation represented by formula (V) and/or (VI):

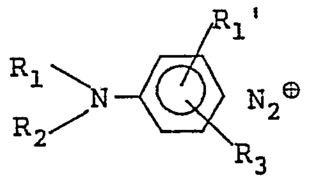

(V)

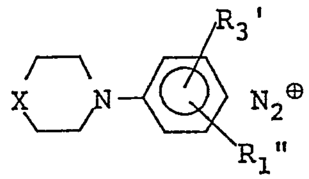

(VI)

wherein $R_1$, $R_1'$, $R_1''$, and $R_2$ each represents a hydrogen atom, an alkyl group or an acetyl group; $R_3$ and $R_3'$ each represents a hydrogen atom, an alkyl group, an acetyl group, a hydroxyl group, an alkoxy group, a halogen atom or a nitrile group; and X represents an oxygen atom, a sulfur atom or $NR_4$, wherein $R_4$ represents a hydrogen atom, an alkyl group or an acetyl group,
and a counter anion represented by formula (I) and/or (II):

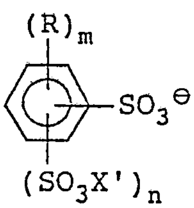

(I)

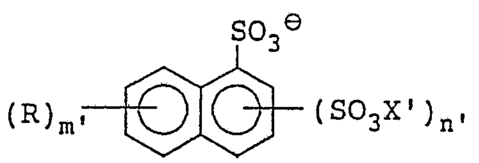

(II)

wherein R represents a hydrogen atom, an alkyl group, an aryl group, an aralkyl group, an alkoxy group, a phenyl group, a halogen atom, a hydroxyl group or a carboxyl group; X′ represents a hydrogen atom, a lithium atom, a sodium atom, a potassium atom or an ammonium group; m and n each represents 0 or an integer of from 1 to 5, provided that the sum of them is not more than 5; and m′ and n′ each represents 0 or an integer of from 1 to 7, provided that the sum of them is not more than 7.

2. A photosensitive resin composition as claimed in claim 1, wherein said polymer has an organic acid group having a pKa of 2 or less.

3. A photosensitive resin composition as claimed in claim 2, wherein said polymer having an organic acid group and having a pKa of 2 or less contains a sulfo group.

4. A photosensitive resin composition as claimed in claim 3, wherein said polymer has a repeating unit represented by structural formula (III):

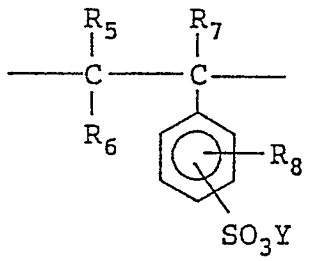

(III)

wherein $R_5$, $R_6$, and $R_7$ each represents a hydrogen atom, an alkyl group having from 1 to 4 carbon atoms, a halogen atom or a nitrile group; $R_8$ represents a hydrogen atom, an alkyl group having from 1 to 4 carbon atoms, a halogen atom, a hydroxyl group or a carboxyl group; and Y represents a hydrogen atom, an alkali metal atom, an alkaline earth metal atom or an ammonium group.

5. A photosensitive resin composition as claimed in claim 1, wherein said polymer is a copolymer containing a structural unit represented by formula (III):

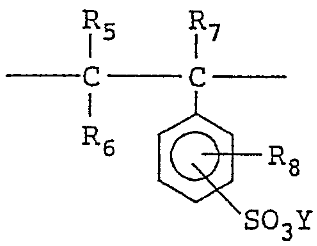

(III)

wherein $R_5$, $R_6$, and $R_7$ each represents a hydrogen atom, an alkyl group having from 1 to 4 carbon atoms, a halogen atom or a nitrile group; $R_8$ represents a hydrogen atom, an alkyl group having from 1 to 4 carbon atoms, a halogen atom, a hydroxyl group or a carboxyl group; and Y represents a hydrogen atom, an alkali metal atom, an alkaline earth metal atom or an ammonium group.

6. A photosensitive resin composition comprising a diazonium salt as a photobleachable reagent, a polymer, and water and/or an organic solvent, wherein said diazonium salt has a counter cation represented by formula (V) and/or (VI):

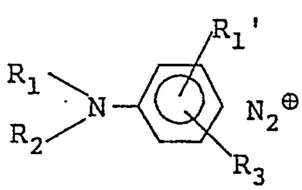

(V)

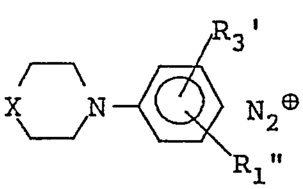

(VI)

wherein $R_1$, $R_1'$, $R_1''$, and $R_2$ each represents a hydrogen atom, an alkyl group or an acetyl group; $R_3$ and $R_3'$ each represents a hydrogen atom, an alkyl group, an acetyl group, a hydroxyl group, an alkoxy group, a halogen atom or a nitrile group; and X represents an oxygen atom, a sulfur atom or $NR_4$, wherein $R_4$ represents a hydrogen atom, an alkyl group or an acetyl group,
and a counter anion that is a functional group of said polymer.

7. A photosensitive resin composition as claimed in claim 6, wherein said functional group of the polymer is a sulfo group.

8. A photosensitive resin composition as claimed in claim 6, wherein said polymer has a repeating unit

represented by structure formula (IV):

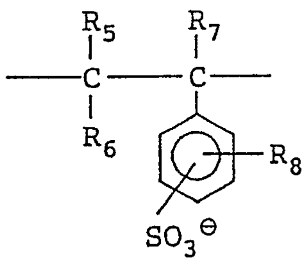

(IV)

wherein $R_5$, $R_6$, and $R_7$ each represents a hydrogen atom, an alkyl group having from 1 to 4 carbon atoms, a halogen atom or a nitrile group; and $R_8$ represents a hydrogen atom, an alkyl group having from 1 to 4 carbon atoms, a halogen atom, a hydroxyl group or a carboxyl group.

9. A photosensitive resin composition as claimed in claim 6, wherein said polymer is a copolymer containing a structural unit represented by formula:

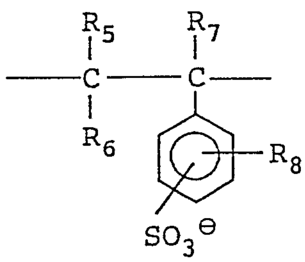

(IV)

wherein $R_5$, $R_6$, and $R_7$ each represents a hydrogen atom, an alkyl group having from 1 to 4 carbon atoms, a halogen atom or a nitrile group; and $R_8$ represents a hydrogen atom, an alkyl group having from 1 to 4 carbon atoms, a halogen atom, a hydroxyl group or a carboxyl group.

10. A photosensitive resin composition comprising a diazonium salt as a photobleachable reagent, a polymer, and water and/or an organic solvent, wherein said diazonium salt has a counter cation represented by formula (V) and/or (VI):

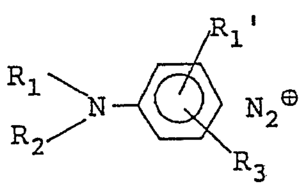

(V)

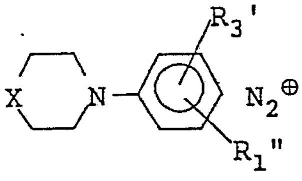

(VI)

wherein $R_1$, $R_1'$, $R_1''$, and $R_2$ each represents a hydrogen atom, an alkyl group or an acetyl group; $R_3$ and $R_3'$ each represents a hydrogen atom, an alkyl group, an acetyl group, a hydroxyl group, an alkoxy group, a halogen atom or a nitrile group; and X represents an oxygen atom, a sulfur atom or $NR_4$, wherein $R_4$ represents a hydrogen atom, an alkyl group or an acetyl group,

and said polymer has a repeating unit represented by structural formula (III):

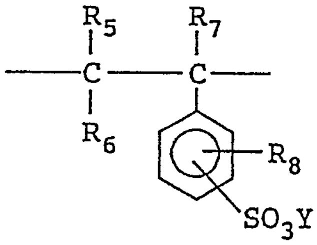

(III)

wherein $R_5$, $R_6$, and $R_7$ each represents a hydrogen atom, an alkyl group having from 1 to 4 carbon atoms, a halogen atom or a nitrile group; $R_8$ represents a hydrogen atom, an alkyl group having from 1 to 4 carbon atoms, a halogen atom, a hydroxyl group or a carboxyl group; and Y represents a hydrogen atom, an alkali metal atom, an alkaline earth metal atom or an ammonium group.

11. A photosensitive resin composition comprising a diazonium salt as a photobleachable reagent, a polymer, water and/or an organic solvent, wherein said diazonium salt has a counter cation represented by formula (V) and/or (VI):

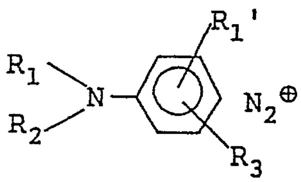

(V)

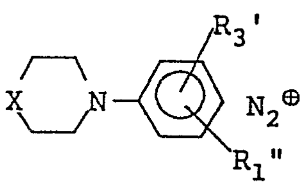

(VI)

wherein $R_1$, $R_1'$, $R_1''$, and $R_2$ each represents a hydrogen atom, an alkyl group or an acetyl group; $R_3$ and $R_3'$ each represents a hydrogen atom, an alkyl group, an acetyl group, a hydroxyl group, an alkoxy group, a halogen atom or a nitrile group; and X represents an oxygen atom, a sulfur atom or $NR_4$, wherein $R_4$ represents a hydrogen atom, an alkyl group or an acetyl group,
and said polymer has a copolymer containing a structural unit represented by formula (III):

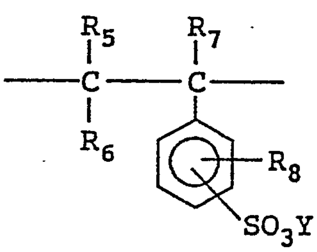

(III)

wherein $R_5$, $R_6$, and $R_7$ each represents a hydrogen atom, an alkyl group having from 1 to 4 carbon atoms, a halogen atom or a nitrile group; $R_8$ represents a hydrogen atom, an alkyl group having from 1 to 4 carbon atoms, a halogen atom, a hydroxyl group or a carboxyl group; and Y represents a hydrogen atom, an alkali metal atom, an alkaline earth metal atom or an ammonium group.

12. A method for forming a pattern comprising exposing both a resist film formed on a substrate as a

lower layer and a photosensitive resin composition layer formed thereon as an upper layer to light simultaneously to form a resist pattern, wherein said photosensitive resin composition is as claimed in any of claims 1 to 11.

13. A photosensitive resin composition including a photobleachable diazonium salt whose counter anion contains bisulphate groups, organic carboxylic acid groups or organic sulphuric acid groups or including a polymer having sulfo groups or a salt thereof.

FIG. 1

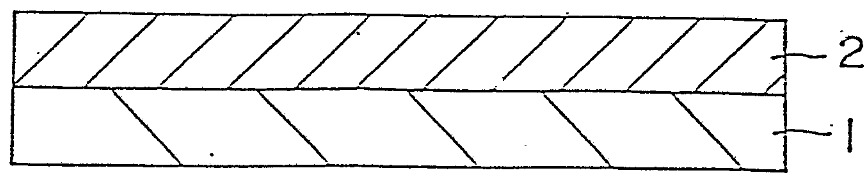


FIG. 2

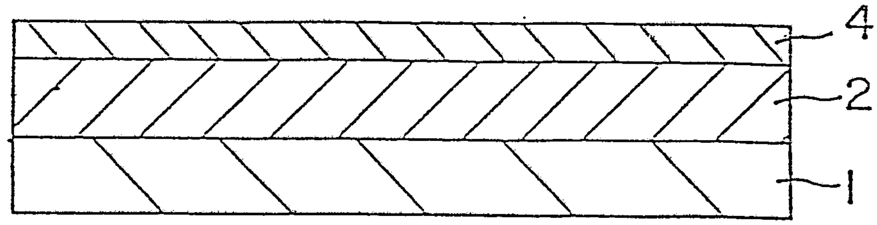


FIG. 3

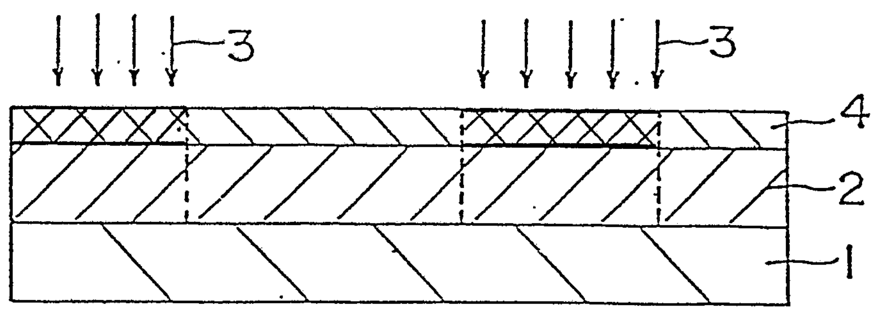


FIG. 4